# EUROPÄISCHE PATENTSCHRIFT

(11) **EP 2 728 982 B1**
(45) Veröffentlichungstag und Bekanntmachung des Hinweises auf die Patenterteilung: **26.07.2017**
(21) Anmeldenummer: 12190542.6
(22) Anmeldetag: 30.10.2012
(51) Int. Cl.: H05K 5/00, H05K 1/11, H05K 1/14, H05K 1/18, B60R 16/023

(54) **Leiterplattenbaugruppe für ein Steuergerät, Steuergerät für ein Kraftfahrzeug und Signalverarbeitungsanordnung**
Circuit board module for a control device, control device for a motor vehicle and signal processing assembly
Composant à plaquettes pour un appareil de commande, appareil de commande pour un véhicule automobile et agencement de traitement du signal

(43) Veröffentlichungstag der Anmeldung: 07.05.2014
(73) Patentinhaber: Continental Automotive GmbH, 30165 Hannover (DE)
(72) Erfinder: Drew, Gregory, 93051 Regensburg (DE); Binder, Manfred, 90451 Nürnberg (DE); Riepl, Thomas, 93077 Bad Abbach (DE)

(56) Entgegenhaltungen:
- EP-A1- 1 575 344
- DE-C1- 19 701 854
- US-A1- 2001 010 303
- US-A1- 2004 014 356
- US-A1- 2005 056 457

## Beschreibung

Die vorliegende Offenbarung betrifft eine Leiterplattenbaugruppe für ein Steuergerät für ein Kraftfahrzeug und eine Signalverarbeitungsanordnung für ein Kraftfahrzeug.

Die EP 1575344 A1 offenbart ein Steuergerät mit einem parallelen Steckerabgang, das sich dadurch auszeichnet, dass der Stecker so kontaktiert ist, dass ein möglichst großer Bereich der Grundfläche einer Leiterplatte mit elektronischen Bauelementen bestückt werden kann und auch ein möglichst großer Bereich dieser mehrlagigen Leiterplatte mit Leiterbahnen zur Verbindung dieser elektronischen Bauelemente versehen werden kann. Dies wird dadurch gelöst, dass ein erster Teil der Leiterplatte mit einem den Steckverbinder tragenden zweiten Teil über einen Biegebereich verbunden ist. Hierbei weisen der erste und zweite Teil zumindest vier Lagen und der Biegebereich zumindest zwei Lagen auf.

Die US 2005/056457 A1 offenbart eine flexible Leiterplattenbaugruppe mit einer flexiblen Leiterplatte, die einen ersten Teil und einen zweiten Teil hat, welche durch einen biegbaren Bereich getrennt sind. Die Baugruppe weist ein im Wesentlichen starres Substrat auf, das einen ersten Teil und einen zweiten Teil hat, die von einem Biegungsbereich getrennt sind. Das starre Substrat hat eine Innenfläche und eine Außenfläche. Der erste und zweite Teil der Leiterplatte sind am entsprechenden ersten bzw. zweiten Teil des starren Substrats befestigt, so dass die Leiterplatte sich biegen muss, wenn das Substrat gebogen wird. Der Biegungsbereich hat eine Ausnehmung, die sich von der Innenfläche des Substrats auswärts erstreckt und zur Aufnahme des biegbaren Bereichs der Leiterlpatte bemessen ist, wenn das Substrat um eine einzige Biegeachse gebogen wird. Mit der Ausnehmung ist ein größerer Biegeradius der Leiterplatte erzielt, so dass Spannungen reduziert sind.

Die Vergrößerung der Funktionalität von Motorsteuergeräten für Kraftfahrzeuge geht mit einer steigenden Anzahl von elektrischen Verbindungselementen einher, mittels welchen Signale vom und/oder zum Steuergerät übermittelt werden.

Die US 2004/014356 A1 offenbart eine elektronische Baugruppe mit auf einem Schaltungsträger angeordneten Bauelementen und Kontaktierungselementen. Im Gehäuse oder mindestens einem Gehäuseteil der elektronischen Baugruppe ist ein Steckeranschluss unter Ermöglichung eines Toleranzausgleichs integriert. Hierzu ist ein in einer Aussparung des Gehäuses bzw. Gehäuseteils beweglich gelagertes, Pindurchbrüche aufweisendes Einsatzteil vorgesehen. Durch ein Übermaß an der Verbindungsstelle von Einsatzteil und Gehäuse bzw. Gehäuseteil wird bei der Bildung des Steckeranschlusses durch Verbindung des Einsatzteils mit dem Schaltungsträger eine Ausrichtung der Pindurchbrüche des Einsatzteils bezüglich der Kontaktierungselemente ermöglicht.

Es ist eine Aufgabe der vorliegenden Offenbarung, ein Steuergerät für ein Kraftfahrzeug anzugeben, bei dem eine besonders platzsparende Anordnung der Verbindungselemente und/oder eine besonders geringe Breite des Steuergeräts erzielbar ist.

Diese Aufgabe wird durch eine Leiterplattenbaugruppe gemäß Anspruch 1 gelöst. Vorteilhafte Ausgestaltungen und Weiterbildungen der Leiterplattenbaugruppe, des Steuergeräts und der Signalverarbeitungsanordnung sind in den abhängigen Ansprüchen angegeben.

Es wird eine Leiterplattenbaugruppe für ein Steuergerät angegeben. Zudem wird ein Steuergerät mit der Leiterplattenbaugruppe angegeben. Bei dem Steuergerät handelt es sich insbesondere um ein Steuergerät für ein Kraftfahrzeug, beispielsweise um ein Motorsteuergerät. Weiter wird eine Signalverarbeitungsanordnung angegeben, die insbesondere die Leiterplattenbaugruppe bzw. das Steuergerät enthält.

Beispielsweise handelt es sich bei der Signalverarbeitungsanordnung um eine Motorsteuerung.

Die Leiterplattenbaugruppe weist eine mehrlagige Leiterplatte und ein Steckerbauteil auf. Unter einer "mehrlagigen Leiterplatte" wird im vorliegenden Zusammenhang verstanden, dass die Leiterplatte mehrere übereinander gestapelte Schaltungsebenen enthält, von denen mindestens eine Schaltungsebene im Inneren eines Grundkörpers der Leiterplatte verläuft. Dabei ist/sind von der/den im Inneren des Grundkörpers verlaufenden Schaltungsebene (n) zweckmäßigerweise elektrische Anschlussleiter zu einer Außenfläche der Leiterplatte gezogen und dort mit elektrischen Anschlussstellen verbunden. Die mehrlagige Leiterplatte hat beispielsweise vier solche gestapelte Schaltungsebenen oder mehr, bei einer Weiterbildung hat sie sechs gestapelte Schaltungsebenen oder mehr. Insbesondere ist die Anzahl der gestapelten Schaltungsebenen kleiner oder gleich 15.

Die Leiterplatte weist einen Hauptabschnitt, einen Anschlussabschnitt und einen gekrümmten Verbindungsabschnitt auf. Der Hauptabschnitt, der gekrümmte Verbindungsabschnitt und der Anschlussabschnitt erfolgen insbesondere in dieser Reihenfolge aufeinander. Mit anderen Worten ist der gekrümmte Verbindungsabschnitt zwischen dem Hauptabschnitt und dem Anschlussabschnitt angeordnet.

Der Hauptabschnitt und der Anschlussabschnitt sind mittels des Verbindungsabschnitts mechanisch und elektrisch leitend miteinander verbunden. Die Verbindung ist mittels des gekrümmten Verbindungsabschnitts derart ausgeführt, dass eine Haupterstreckungsebene des Hauptabschnitts geneigt zu einer Haupterstreckungsebene des Anschlussabschnitts verläuft. Insbesondere stehen die Haupterstreckungsebene des Hauptabschnitts und die Haupterstreckungsebene des Anschlussabschnitts senkrecht aufeinander. Die Haupterstreckungsebenen sind dabei insbesondere parallel zu den Schaltungsebenen und/oder zu einer zur Bestückung vorgesehenen Hauptfläche des jeweiligen Abschnitts. Der Hauptabschnitt, der Verbindungsabschnitt und der Anschlussabschnitt sind insbesondere einstückig ausgebildet.

Bei einer bevorzugten Ausgestaltung ist der Verbindungsabschnitt semiflexibel ausgebildet. Dies ist insbesondere dadurch erzielt, dass der Verbindungsabschnitt eine gegenüber dem Hauptabschnitt und dem Anschlussabschnitt verringerte Dicke hat und ein glasfaserverstärktes Harz aufweist. Die Dicke ist insbesondere die Ausdehnung senkrecht zu den Haupterstreckungsebenen des Hauptabschnitts bzw. des Anschlussabschnitts im gestreckten Zustand der Leiterplatte, das heißt, bei paralleler Ausrichtung der Haupterstreckungsebenen des Hauptabschnitts und des Anschlussabschnitts.

Dass der Verbindungsbereich "semiflexibel" ist bedeutet insbesondere, dass er krümmbar ist. Beispielsweise ist er derart umformbar, dass er durch Biegen - etwa mittels Krafteinwirkung auf den Hauptabschnitt und auf den Anschlussabschnitt der Leiterplatte - von einer gestreckten Form in eine gekrümmte Form überführbar ist. Dabei ist die Leiterplatte für mindestens einen und insbesondere für höchstens 20, beispielsweise höchstens zehn Biegezykel ausgelegt. Der Verbindungsbereich ist dabei aufgrund seiner semiflexiblen Ausbildung vorzugsweise derart formstabil, dass er nach dem Biegen ohne die Einwirkung äußerer Kräfte (abgesehen von der Gewichtskraft der Leiterplatte) in der gekrümmten Form verharrt.

Als "glasfaserverstärktes Harz" wird im vorliegenden Zusammenhang ein Faser-Harz-Verbund aus einem Harz und Glasfasern verstanden. Bei dem Harz handelt es sich beispielsweise um ein duroplastisches Material wie Polyesterharz oder, bevorzugt, Epoxidharz. Das glasfaserverstärkte Harz bildet insbesondere den Grundkörper der Leiterplatte, zumindest im Bereich des Verbindungsabschnitts, vorzugsweise auch im Bereich des Anschlussabschnitts und des Hauptabschnitts. Die Schaltungsebenen mit den elektrischen Leiterbahnen der Leiterplatte sind insbesondere in das glasfaserverstärkte Harz eingebettet und/oder auf dieses aufgebracht.

Das Steckerbauteil weist mindestens einen Steckverbinder auf. Bei zumindest einer Ausgestaltung weist es eine Mehrzahl von Steckverbindern, das heißt mindestens einen weiteren Steckverbinder, auf. Beispielsweise weist das Steckerbauteil vier oder mehr, vorzugsweise sechs oder mehr Steckverbinder auf. Bei einer Ausgestaltung enthält es zehn oder weniger Steckverbinder. Der Steckverbinder bzw. die Steckverbinder weisen jeweils eine Mehrzahl von Verbindungselementen auf. Die Verbindungselemente sind bei einer Ausgestaltung in Reihen oder in Reihen und Spalten angeordnet. Die Verbindungselemente haben jeweils ein Anschlussteil und einen Kontaktstift.

Das Anschlussteil ist insbesondere zur externen elektrischen Kontaktierung des Steuergeräts vorgesehen, insbesondere zur Signalübermittlung an das Steuergerät und/oder vom Steuergerät. Die Anschlussteile sind beispielsweise als Stifte (sogenannte Pins), Hohlstifte, Buchsen oder dergleichen ausgebildet.

Die Anschlussteile eines Steckverbinders - insbesondere eines jeden der Steckverbinder - sind jeweils in einer gemeinsamen Einfassung angeordnet. Beispielsweise weist das Steckerbauteil eine Gehäuseblende auf. Die Einfassung ragt insbesondere aus der Gehäuseblende des Steckerbauteils heraus.

Bei einer bevorzugten Ausgestaltung befinden sich die Einfassung bzw. die Einfassungen und der Anschlussabschnitt der Leiterplatte auf gegenüberliegenden Seiten der Gehäuseblende. Die Anschlussteile sind zweckmäßigerweise auf der von dem Anschlussabschnitt abgewandten Seite der Gehäuseblende angeordnet. Die Verbindungselemente verlaufen bei einer zweckmäßigen Ausgestaltung durch die Gehäuseblende hindurch. Beispielsweise sind sie stellenweise mit der Gehäuseblende umspritzt oder umgossen.

Die Kontaktstifte sind elektrisch und mechanisch mit dem Anschlussabschnitt der Leiterplatte verbunden. Beispielsweise sind sie mit dem Anschlussabschnitt verlötet und/oder verpresst. Sie haben mit Vorteil eine Haupterstreckungsrichtung, die senkrecht zur Haupterstreckungsrichtung des Anschlussabschnitts verläuft.

Gemäß zumindest einer Ausgestaltung weist das Steckerbauteil eine Mehrzahl von Steckverbindern auf, die in einer ersten Steckverbinder-Reihe und einer zweiten Steckverbinder-Reihe angeordnet sind. Beispielsweise weist jede Steckverbinder-Reihe zwei oder mehr Steckverbinder auf, zum Beispiel weist jede Steckverbinder-Reihe zwei, drei, vier oder fünf Steckverbinder auf. Die erste und die zweite Steckverbinder-Reihe folgen in einer zu der Haupterstreckungsebene des Hauptabschnitts geneigten Stapelrichtung auf einander, so dass die erste Steckverbinder-Reihe einen größeren Abstand von dem Hauptabschnitt hat als die zweite Steckverbinder-Reihe. Insbesondere ist die Stapelrichtung parallel zu der Haupterstreckungsebene des Anschlussabschnitts. Die Anzahl der Verbindungselemente eines, insbesondere eines jeden, der Steckverbinder, die in der Stapelrichtung aufeinander folgen, ist insbesondere in Stapelrichtung kleiner als senkrecht dazu. Insbesondere haben die Steckverbinder in Reihungsrichtung, d.h. in Draufsicht auf die Haupterstreckungsebene des Anschlussabschnitts senkrecht zur Stapelrichtung, eine größere Ausdehnung als in Stapelrichtung.

Die Anordnung der Verbindungselemente in mehreren Steckverbindern ist gegenüber der Anordnung in einem größeren Steckverbinder wegen des zum Herstellen der Steckverbindung erforderlichen Kraftaufwands pro Steckverbinder vorteilhaft. Mit Vorteil kann bei der Anordnung der Steckverbinder in zwei übereinander angeordneten Reihen die Breite der Leiterplattenbaugruppe - und damit des Steuergeräts - auch bei vergrößerter Anzahl der Verbindungselemente beibehalten werden. Auf diese Weise sind die Leiterplattenbaugruppe und das Steuergerät besonders kosteneffizient herstellbar und besonders platzsparend. Die Verteilung von Steckverbindern auf unterschiedliche Seiten der Leiterplattenbaugruppe bzw. des Steuergeräts ist mit Vorteil nicht erforderlich, so dass die Leiterplattenbaugruppe besonders einfach anschließbar und kostengünstig ist. Die Kontaktierung mittels der Kontaktstifte, die sich senkrecht zu dem Anschlussabschnitt erstrecken und dem zum Hauptabschnitt geneigt verlaufenden Anschlussabschnitt ist dabei - im wesentlichen unabhängig von der Ausdehnung des Steckerbauteils der Stapelrichtung - besonders platzsparend, kurzschlusssicher und - mittels des semiflexiblen, gekrümmten Verbindungsabschnitts - vergleichsweise formstabil.

Bei einer Ausgestaltung hat der Anschlussabschnitt der Leiterplatte in Draufsicht auf seiner Haupterstreckungsebene eine rechteckige Grundform. Vorzugsweise hat er die gleich Breite wie der Hauptabschnitt. Die Breite ist dabei die Abmessung in der Richtung, die in Draufsicht auf die Leiterplatte im gestreckten Zustand senkrecht zu derjenigen Richtung ist, in der der Anschlussabschnitt, der semiflexible Verbindungsabschnitt und der Hauptabschnitt aufeinander folgen. Insbesondere hat die Leiterplatte insgesamt eine - in Draufsicht auf die Haupterstreckungsebenen im gestreckten Zustand - rechteckige Grundform. Solche Leiterplatten sind besonders kostengünstig herstellbar. Zudem ist auf diese Weise eine besonders große Grundfläche des Anschlussabschnitts erzielbar, so dass dieser besonders gut zur elektrischen Verschaltung der Verbindungselemente und zur Signalverarbeitung nutzbar ist. Auf diese Weise sind kurze Signalwege erzielbar, so dass die Störanfälligkeit besonders gering ist.

Beispielsweise sind ein erstes und ein zweites der Verbindungselemente, insbesondere zur Signaldurchführung von dem ersten zu dem zweiten Verbindungselement oder zur Leitung mehrerer Signale zu einem elektronischen Bauelement der Leiterplattenbaugruppe hin, elektrisch leitend verbunden. Das erste und das zweite Verbindungselement sind einander beispielsweise nicht unmittelbar benachbart, das bedeutet insbesondere, dass in Stapelrichtung oder senkrecht zur Stapelrichtung mindestens ein weiteres Verbindungselement zwischen dem ersten und dem zweiten Verbindungselement angeordnet ist. Beispielsweise ist das erste Verbindungselement von einem ersten der Steckverbinder umfasst, und das zweite Verbindungselement ist von einem zweiten der Steckverbinder umfasst, der von dem ersten Steckverbinder verschieden ist.

Gemäß zumindest einer Ausgestaltung weist der Anschlussabschnitt mindestens ein elektronisches Bauelement auf. Mittels des mindestens einen elektronischen Bauelements ist der Anschlussabschnitt vorzugsweise dazu vorgesehen, eine an einem der Verbindungselemente anliegende Überspannung zu filtern und/oder ein an einem der Verbindungselemente anliegendes Signal zu glätten und/oder einen an einem der Verbindungselemente anliegendes Signal zu verstärken.

Gemäß zumindest einer Ausgestaltung ist die Breite der ersten Steckverbinder-Reihe mindestens genauso groß oder höchstens 10 % kleiner als die Breite der zweiten Steckverbinder-Reihe. Eine solche Ausgestaltung erlaubt mit Vorteil eine besonders große Anzahl von Verbindungselementen, bezogen auf die Breite des Steuergeräts.

Gemäß zumindest einer weiteren Ausgestaltung weist die Gehäuseblende des Steckerbauteils einen ersten Dichtungsabschnitt und einen zweiten Dichtungsabschnitt auf. Die Dichtungsabschnitte sind zweckmäßigerweise dazu vorgesehen, zur Abdichtung des Steuergeräts jeweils mit einem korrespondierenden Dichtungsabschnitt eines Gehäusebauteils des Steuergeräts zusammenzuwirken. Beispielsweise wird auf den ersten bzw. zweiten Dichtungsabschnitt der Gehäuseblende und/oder auf den korrespondierenden jeweiligen Dichtungsabschnitt des Gehäusebauteils eine Dichtungsmasse aufgetragen und bei der Montage des Steuergeräts zwischen dem ersten bzw. dem zweiten Dichtungsabschnitt der Gehäuseblende und dem korrespondierenden Dichtungsabschnitt des Gehäusebauteils zusammengepresst.

Der erste und der zweite Dichtungsabschnitt der Gehäuseblende verlaufen geneigt zur Haupterstreckungsebene des Hauptabschnitts der Leiterplatte. Vorzugsweise verlaufen sie auch geneigt zur Haupterstreckungsebene des Anschlussabschnitts der Leiterplatte. Bei einer Ausgestaltung verlaufen der erste und der zweite Dichtungsabschnitt in einem Winkel zwischen 50 Grad und 80 Grad, vorzugsweise zwischen 60 Grad und 70 Grad zur Haupterstreckungsebene des Hauptabschnitts der Leiterplatte, wobei die Grenzen jeweils eingeschlossen sind. Bei einer anderen Weiterbildung verlaufen der erste und der zweite Dichtungsabschnitt parallel zu einer zur Haupterstreckungsebene des Anschlussabschnitts senkrechten Ebene. Besonders bevorzugt verlaufen sie parallel zu einer Ebene, die durch die Normalenvektoren auf die Haupterstreckungsebenen des Hauptabschnitts und des Anschlussabschnitts aufgespannt wird. Beispielsweise verlaufen sie in Draufsicht auf die Haupterstreckungsebene des Hauptabschnitts parallel zu dessen Längsflanken. Die Längsflanken des Hauptabschnitts sind dabei die an den Verbindungsabschnitt angrenzenden und in Richtung vom Anschlussabschnitt weg verlaufenden Seitenflanken des Hauptabschnitts. Als Seitenflanken dabei werden die den Hauptabschnitt in Draufsicht auf die Haupterstreckungsebene lateral begrenzenden Seitenflächen bezeichnet.

Der Hauptabschnitt - genauer ein Teilstück des Hauptabschnitts - der Leiterplatte ist vorzugsweise in Draufsicht auf die Haupterstreckungsebene des Hauptabschnitts zwischen dem ersten und dem zweiten Dichtungsabschnitt angeordnet. Anders ausgedrückt folgen der erste Dichtungsabschnitt, die Leiterplatte und der zweite Dichtungsabschnitt in einer lateralen Richtung - d.h. insbesondere senkrecht zum Normalenvektor auf die Haupterstreckungsebene des Hauptabschnitts - in dieser Reihenfolge aufeinander. Auf diese Weise sind der erste und der zweite Dichtungsabschnitt mit Vorteil an Seitenwänden des Steuergeräts angeordnet, welche zu der Seitenwand, die die Steckverbinder aufweist, gewinkelt sind. So ist der für die Steckverbinder zur Verfügung stehende Platz auf der letztgenannten Seitenwand mit Vorteil besonders groß.

Mittels des zum Hauptabschnitt geneigten Verlaufs der Dichtungsabschnitte ist eine zufriedenstellende Dichtwirkung zwischen den Dichtungsabschnitten und den Dichtungsabschnitten des korrespondierenden Gehäusebauteils erzielbar, wenn das Gehäusebauteil senkrecht - das heißt in Richtung entlang des Normalenvektors auf die Haupterstreckungsebene des Hauptabschnitts - auf die Leiterplattenbaugruppe aufgesetzt wird. Eine solche Herstellungsweise ist besonders einfach und kostengünstig.

Der Verlauf des ersten und zweiten Dichtungsabschnitts in einer zur Haupterstreckungsebene des Anschlussabschnitts senkrechten Ebene und der zum Hauptabschnitt geneigte Verlauf des Anschlussabschnitts mittels des gekrümmten Verbindungsabschnitts der Leiterplatte ermöglicht mit Vorteil eine besonders große Oberfläche der Leiterplatte. Diese kann sich im Bereich des Anschlussabschnitts im Wesentlichen über die gesamte Breite des Steuergeräts erstreckt und dabei eine vorteilhafte, nämlich rechteckige, Grundform haben. Insbesondere kann auf eine Verringerung der Breite des Anschlussabschnitts in Richtung von dem Hauptabschnitt weg, die beispielsweise zu einer trapezoiden Grundform des Anschlussabschnitts führt, verzichtet werden.

Die Signalverarbeitungsvorrichtung weist bevorzugt einen Kabelbaum auf, der an das Steckerbauteil angeschlossen ist. Der Kabelbaum ist vorzugsweise frei von Spleißstellen. Zwei Kabel des Kabelbaums sind mittels eines ersten und eines zweiten der Verbindungselemente und einer Leiterbahn des Anschlussabschnitts elektrisch leitend miteinander verbunden. Ein solcher, von Spleißstellen freier Kabelbaum ist besonders einfach, insbesondere maschinell, und kostengünstig herstellbar.

Gemäß einem Aspekt wird eine Leiterplattenbaugruppe für ein Steuergerät eines Kraftfahrzeugs mit einer mehrlagigen Leiterplatte und einem Steckerbauteil angegeben. Die Leiterplatte weist einen Hauptabschnitt und einen Anschlussabschnitt sowie einen gekrümmten Verbindungsabschnitt auf, der zwischen dem Hauptabschnitt und dem Anschlussabschnitt angeordnet ist und diese mechanisch und elektrisch derart verbindet, dass eine Haupterstreckungsebene des Hauptabschnitts geneigt zu einer Haupterstreckungsebene des Anschlussabschnitts verläuft. Das Steckerbauteil weist eine erste und eine zweite Steckverbinder-Reihe auf, die jeweils mindestens einen Steckverbinder enthalten. Jeder Steckverbinder weist eine Mehrzahl von Verbindungselementen mit einem Anschlussteil und einem Kontaktstift auf, wobei die Anschlussteile in einer gemeinsamen Einfassung angeordnet sind und die Kontaktstifte elektrisch und mechanisch mit dem Anschlussabschnitt verbunden sind und eine Haupterstreckungsrichtung haben, die senkrecht zur Haupterstreckungsebene des Anschlussabschnitts verläuft. Die erste und die zweite Steckverbinder-Reihe folgen in einer zu der Haupterstreckungsebene des Hauptabschnitts geneigten Stapelrichtung aufeinander, derart dass die erste Steckverbinder-Reihe einen größeren Abstand von dem Hauptabschnitt hat als die zweite Steckverbinder-Reihe. Der gekrümmte Verbindungsabschnitt ist mittels einer gegenüber dem Hauptabschnitt und dem Anschlussabschnitt verringerten Dicke und eines glasfaserverstärkten Harzes semiflexibel ausgebildet.

Mit Vorteil ist bei der Leiterplattenbaugruppe auch bei vergrößerter Anzahl der Verbindungselemente keine Vergrößerung der Breite erforderlich. Die Kontaktierung mittels der Kontaktstifte, die sich senkrecht zu dem Anschlussabschnitt erstrecken und dem zum Hauptabschnitt geneigt verlaufenden Anschlussabschnitt ist dabei - im wesentlichen unabhängig von der Ausdehnung des Steckerbauteils in der Stapelrichtung - besonders platzsparend, kurzschlusssicher und - mittels des semiflexiblen, gekrümmten Verbindungsabschnitts - vergleichsweise formstabil. Auf diese Weise sind die Leiterplattenbaugruppe und das Steuergerät besonders kosteneffizient herstellbar und besonders platzsparend.

Weitere Vorteile und vorteilhafte Ausgestaltungen und Weiterbildungen der Leiterplattenbaugruppe und des Steuergeräts sowie der Signalverarbeitungsanordnung ergeben sich aus den folgenden, in Zusammenhang mit den Figuren dargestellten Ausführungsbeispielen.

Es zeigen:
- Figur 1,: eine schematische perspektivische Darstellung einer Leiterplattenbaugruppe gemäß einem ersten Ausführungsbeispiel,
- Figur 2,: einen nicht maßstabsgetreuen schematischen Querschnitt durch die Leiterplattenbaugruppe gemäß dem ersten Ausführungsbeispiel,
- Figur 3A,: einen nicht maßstabsgetreuen schematischen Querschnitt durch einen Ausschnitt der Leiterplatte der Leiterplattenbaugruppe des ersten Ausführungsbeispiels und
- Figur 3B,: eine nicht maßstabsgetreue schematische Draufsicht auf den Ausschnitt der Leiterplatte gemäß Figur 3a,
- Figur 4,: eine perspektivische Ansicht eines Ausführungsbeispiels eines Steuergeräts mit der Leiterplattenbaugruppe gemäß dem ersten Ausführungsbeispiel,
- Figur 5,: eine Seitenansicht des Steuergeräts gemäß dem Ausführungsbeispiel der Figur 4, und
- Figur 6,: eine nicht maßstabsgetreue schematische Seitenansicht eines Ausführungsbeispiels einer Signalverarbeitungsanordnung mit der Leiterplattenbaugruppe gemäß dem ersten Ausführungsbeispiel.

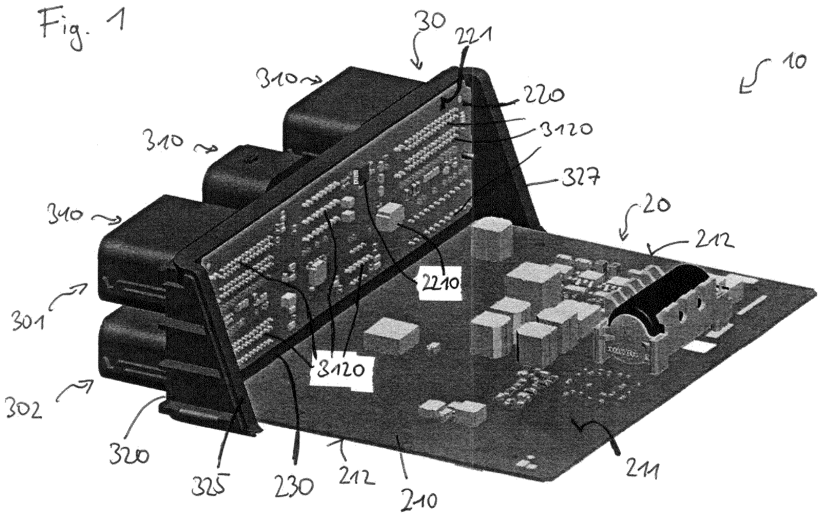

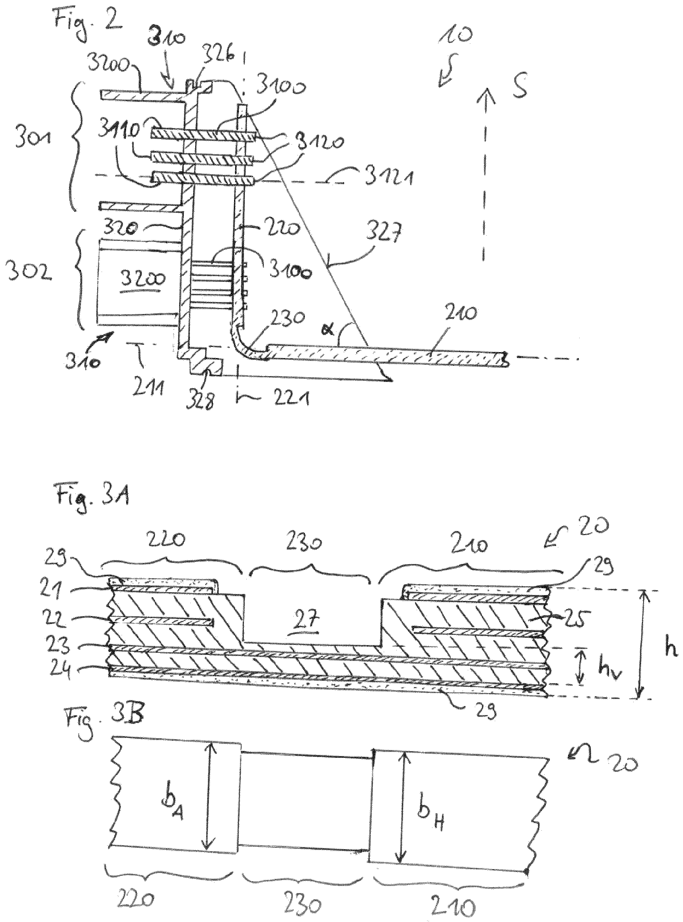

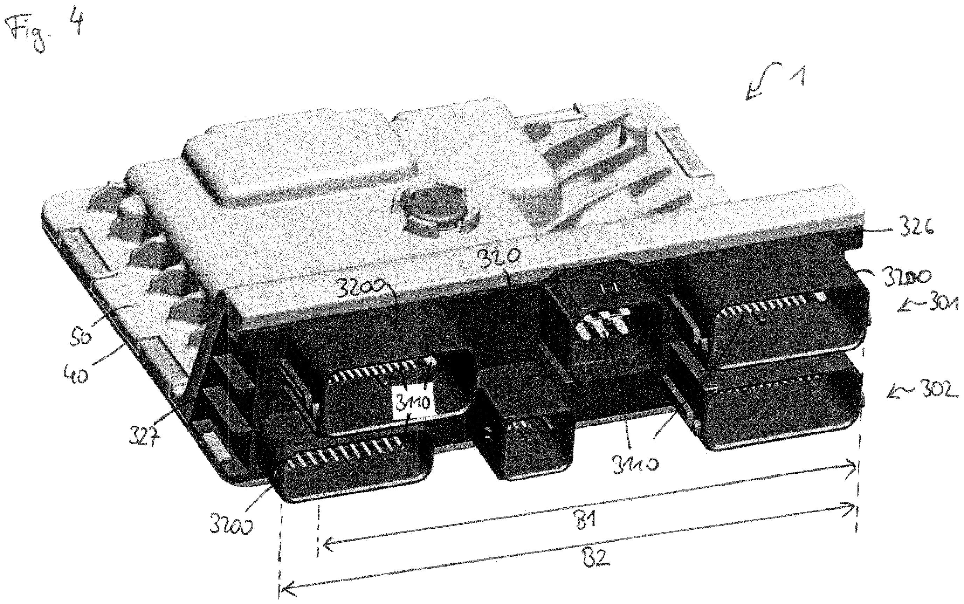

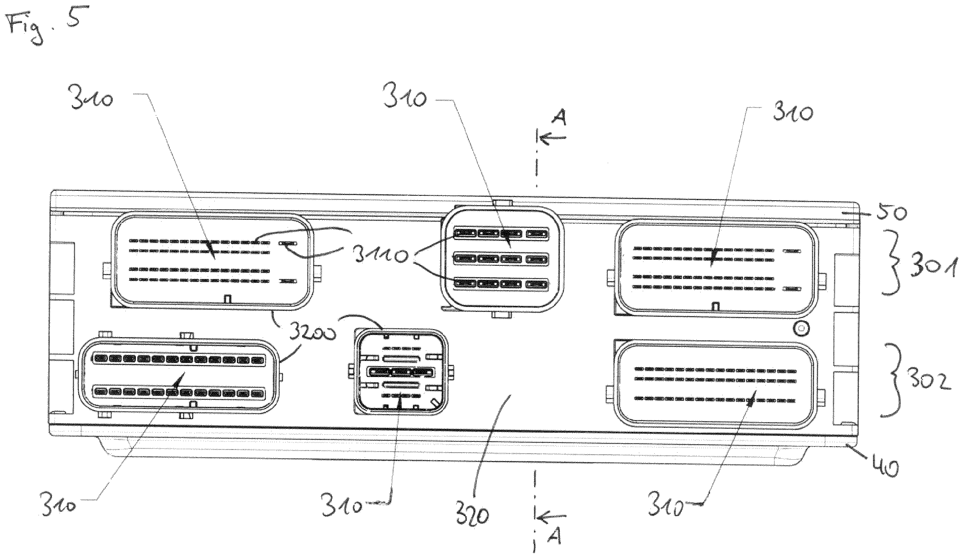

Figur 1 zeigt eine schematische perspektivische Ansicht einer Leiterplattenbaugruppe gemäß einem ersten Ausführungsbeispiel. Figur 2 zeigt einen schematischen Querschnitt durch die Leiterplattenbaugruppe 10 in der Schnittebene A-A. Figur 4 zeigt eine schematische perspektivische Ansicht eines Steuergerätes 1 mit der Leiterplattenbaugruppe 10. Die perspektivische Ansicht der Figur 4 ist gegenüber derjenigen der Figur 1 gedreht. Figur 5 zeigt eine Seitenansicht des Steuergeräts der Figur 4, in der die Schnittebene A-A markiert ist.

Die Leiterplattenbaugruppe 10 weist eine Leiterplatte 20 und ein Steckerbauteil 30 auf.

Die Figur 3A zeigt einen schematischen Querschnitt und die Figur 3B eine schematische Draufsicht auf einen Ausschnitt der Leiterplatte 20.

Die Leiterplatte 20 ist eine mehrlagige Leiterplatte. Sie weist einen Grundkörper 25 auf, der mit Leiterbahnen 21, 22, 23, 24 in mehreren übereinander gestapelten Schaltungsebenen versehen ist. Vorliegend handelt es sich um eine vierlagige Leiterplatte 20, bei der die Leiterbahnen von zwei Schaltungsebenen 22, 23 in den Grundkörper 25 eingebettet sind und die Leiterbahnen von zwei weiteren Schaltungsebenen 21, 24 auf gegenüberliegenden Außenflächen des Grundkörpers 25 aufgebracht sind. Die auf die Außenflächen des Grundkörpers 25 aufgebrachten Leiterbahnen 21, 24 können beispielsweise mit einer Lötstopp-Lackschicht 29 stellenweise abgedeckt sein, wobei zweckmäßigerweise von der Lötstopp-Lackschicht 29 unbedeckte Anschlussstellen verbleiben. Die Leiterbahnen 23, 24 der in den Grundkörper 25 eingebetteten Schaltungsebenen sind beispielsweise mittels in den Zeichnungen nicht dargestellten Durchkontaktierungen (sogenannten "Vias") zu elektrischen Anschlussstellen an mindestens einer Außenfläche des Grundkörpers 25 geführt, so dass sie dort elektrisch leitend verbindbar sind.

Die Leiterplatte 20 enthält eine Vertiefung 27, insbesondere eine Ausfräsung, die sich in einer lateralen Richtung über die gesamte Breite der Leiterplatte 20 erstreckt. Im Bereich der Vertiefung 27 ist die Dicke hᵥ des Grundkörpers 25 reduziert. Insbesondere durchdringt die Vertiefung in der Richtung, in der die Schaltungsebenen aufeinanderfolgen vorliegend zwei der Schaltungsebenen, zu denen die Leiterbahnen 21 und 22 in Figur 3A gehören. Beispielsweise beträgt die Dicke hᵥ im Bereich der Vertiefung 27 0,5 mm oder weniger, vorzugsweise 0,25 mm oder weniger. Bei einer Ausgestaltung beträgt sie 0,1 mm oder mehr. Die gesamte Dicke h der Leiterplatte 20 beträgt beispielsweise 1 mm oder mehr, insbesondere 1,5 mm oder mehr. Bei einer Ausgestaltung beträgt sie 2,5 mm oder weniger.

Mittels der Vertiefung 27 ist ein Verbindungsabschnitt 230 der Leiterplatte 20 ausgebildet, der zwischen einem Hauptabschnitt 210 und einem Anschlussabschnitt 220 der Leiterplatte 20 angeordnet ist und diese mechanisch und elektrisch verbindet. Die elektrische Verbindung wird beispielsweise mittels der in zwei verschiedenen Schaltungsebenen angeordneten Leiterbahnen 23 und 24 hergestellt, die vom Hauptabschnitt 210 durch den Verbindungsbereich 230 hindurch zum Anschlussabschnitt 220 verlaufen.

Der Grundkörper 25 weist - zumindest im Bereich des Verbindungsabschnitt 230, vorzugsweise auch im Bereich des Hauptabschnitts 210 und des Anschlussabschnitts 220, ein glasfaserverstärktes Epoxidharz auf. Mittels des glasfaserverstärkten Epoxidharz und der reduzierten Dicke hᵥ ist der Verbindungsbereich 230 semiflexibel ausgebildet, so dass er durch Biegen krümmend verformbar ist, wobei die Leiterplatte 20 für mindestens zwei und höchstens zehn Biegezykel ausgelegt ist.

Während in den Figuren 3A und 3B die Leiterplatte 20 im gestreckten Zustand dargestellt ist, ist der Verbindungsbereich 230 der Leiterplatte 20 im eingebauten Zustand in der Leiterplattenbaugruppe 10 (siehe beispielsweise die Figur 2) derart gekrümmt, dass eine Haupterstreckungsebene 211 des Hauptabschnitts 210 eine Haupterstreckungsebene 221 des Anschlussabschnittes 220 geneigt - im vorliegenden Ausführungsbeispiel senkrecht- zueinander verlaufen. Der Verbindungsbereich 230 ist dabei aufgrund seiner semiflexiblen Ausbildung vorzugsweise derart formstabil, dass er nach dem Biegen ohne die Einwirkung äußerer Kräfte auf die Leiterplatte 20 in der gekrümmten Form verbleibt.

Die Leiterplattenbaugruppe 10 weist weiter ein Steckerbauteil 30 auf, das eine Mehrzahl von Steckverbindern 310 und eine Gehäuseblende 320 umfasst. Die Gehäuseblende 320 bildet beispielsweise zusammen mit einem ersten Gehäusebauteil und einem zweiten Gehäusebauteil 50 ein Gehäuse des Steuergeräts 1 (siehe Figur 4). Bei dem Steuergerät 1 ist die Leiterplatte 20 in dem Gehäuse angeordnet.

Die Steckverbinder 310 sind in zwei Reihen, einer ersten Steckverbinder-Reihe 301 und einer zweiten Steckverbinder-Reihe 302 angeordnet. Bei dem vorliegenden Ausführungsbeispiel folgen in der Reihe - d. h. in der Reihungsrichtung - jeweils drei Steckverbinder 310 aufeinander. Die erste und die zweite Steckverbinder-Reihe 301, 302 folgen in einer Stapelrichtung S aufeinander. Die Stapelrichtung S ist zur Haupterstreckungsebene 211 des Hauptabschnitts 210 geneigt, vorliegend senkrecht. Auf diese Weise haben die Steckverbinder 310, die in der ersten Steckverbinder-Reihe 301 angeordnet sind, einen größeren Abstand von dem Hauptabschnitt 210 als die in der zweiten Steckverbinder-Reihe 302 angeordneten Steckverbinder 310. Zudem verläuft die Stapelrichtung S vorliegend parallel zu der Haupterstreckungsebene 221 des Anschlussabschnitts 220 der Leiterplatte. Insbesondere stehen vorliegend und bevorzugt die Stapelrichtung S, der Normalenvektor auf die Haupterstreckungsebene des Anschlussabschnitts 220 und die Reihungsrichtung jeweils senkrecht aufeinander.

Jeder Steckverbinder 310 hat ein elektrisches Anschlussfeld mit einer Mehrzahl von Verbindungselementen 3100. Die Verbindungselemente 3100 weisen jeweils ein Anschlussteil 3110 und einen Kontaktstift 3120 auf, die beispielsweise einstückig ausgebildet sind. Die Anschlussteile 3110 der jeweiligen Anschlussfelder sind jeweils in parallel zur Reihungsrichtung verlaufenden Reihen angeordnet, wobei mehrere Reihen in der Stapelrichtung S aufeinander folgen. Zumindest einige der Anschlussteile 3110 sind jeweils in parallel zur Stapelrichtung verlaufenden Spalten angeordnet.

Die Anschlussteile 3110 ragen aus einer von dem Anschlussabschnitt 220 der Leiterplatte 20 abgewandten Seite der Gehäuseblende 320 aus dieser heraus. Sie sind in einer gemeinsamen Einfassung 3200 angeordnet, die ebenfalls auf der von dem Anschlussabschnitt 220 abgewandten Seite aus der Gehäuseblende 320 herausragt. Die Einfassungen können beispielsweise in Reihungsrichtung und in Stapelrichtung die gleiche Ausdehnung haben. Alternativ können sie beispielsweise in Reihungsrichtung eine größere Ausdehnung haben als in Stapelrichtung.

Die Kontaktstifte 3320 ragen auf der dem Anschlussabschnitt 220 zugewandten Seite der Gehäuseblende 320 aus dieser heraus und sind elektrisch und mechanisch mit dem Anschlussabschnitt 220 verbunden, insbesondere mit jeweils einer der Leiterbahnen 21, 22, 23 oder 24. Insbesondere sind sie mit einer Leiterbahn 21-24 des Anschlussabschnitts 220 verlötet oder mit dem Anschlussabschnitt 220 unter Herstellung eines elektrischen und mechanischen Kontakts ohne Löten verpresst.

Die Kontaktstifte 3120 haben eine Haupterstreckungsrichtung 3121, die senkrecht zu der Haupterstreckungsebene 221 des Anschlussabschnitts 220 verläuft. Auf diese Weise ist eine besonders platzsparende Verbindung der Kontaktstifte 3120 mit der Leiterplatte 20 erzielbar und die Verbindung zwischen der Leiterplatte 20 und dem Steckerbauteil 30 ist besonders einfach herstellbar. Beispielsweise kann mit Vorteil auf schräg zur Leiterplatte verlaufende elektrische Verbindungsleitungen verzichtet werden. In der Stapelrichtung S ist die Leiterplattenbaugruppe 10 auf diese Weise besonders einfach über einen großen Bereich skalierbar.

Der Anschlussabschnitt 220 und der Hauptabschnitt 210 haben vorwiegend die gleich Breite b_{A} bzw. b_{H}. Die Breite ist dabei die laterale Ausdehnung senkrecht zu der Richtung, in der im gestreckten Zustand der Leiterplatte 20 der Hauptabschnitt 210, der Verbindungsabschnitt 230 und der Anschlussabschnitt 220 aufeinander folgen (siehe z.B. Figur 3B). Der Verbindungsabschnitt 230 kann die gleiche Breite b_{A}, b_{H} haben wie der Anschlussabschnitt 220 bzw. Hauptabschnitt 210. Die Breite des Verbindungsabschnitts kann jedoch auch geringer sein, wie in Figur 3B angedeutet, beispielsweise zur Einstellung der Flexibilität des Verbindungsbereichs 230.

Der Anschlussabschnitt 220 hat zudem in Draufsicht auf seine Haupterstreckungsebene 221 eine rechteckige Grundform (siehe z.B. Figur 1). Das bedeutet insbesondere, dass der Anschlussabschnitt 220 eine bis auf Aussparungen, die beispielsweise als Justierhilfe vorgesehen sein können, rechteckige Außenkontur hat. Auf diese Weise ist eine besonders große Breite B1 der ersten Steckverbinder-Reihe 301 erzielbar. Insbesondere sind die Breiten B1, B2 der ersten Steckverbinder-Reihe 301 und der zweiten Steckverbinder-Reihe 302 im Wesentlichen gleich groß (siehe beispielsweise Figuren 4 und 5), d.h. insbesondere weichen die Breiten B1 und B2 um 10 % oder weniger voneinander ab. Im vorliegenden Ausführungsbeispiel ist die Breite B1 der ersten Steckverbinder-Reihe 310 um etwa 6% kleiner als die Breite B2 der zweiten Steckverbinder-Reihe 302. Bei einer Variante dieses Ausführungsbeispiels haben die Breiten B1 und B2 den gleichen Wert.

Der rechteckförmige Anschlussabschnitt 220, der die gleiche Breite aufweist wie der Hauptabschnitt 210, bietet genug Platz um zusätzlich zur Kontaktierung der Verbindungselemente 3100 elektronische Bauelemente 2210 auf dem Anschlussabschnitt 220 anzuordnen. Diese können beispielsweise dazu vorgesehen sein, eine an einem oder mehreren Verbindungselemente anliegende Überspannung zu filtern, ein an einem der Verbindungselemente anliegendes Signal zu glätten und/oder einen an einem der Verbindungselemente anliegendes Signal zu verstärken. Die elektrischen Leitungswege von den Verbindungselementen 2100 zu den auf dem Anschlussabschnitt 220 angeordneten Bauelementen 2210 sind mit Vorteil besonders kurz, so dass ein besonders geringer Verlust von Signalqualität und eine besonders geringe Störanfälligkeit erzielbar sind.

Zudem können zwei Verbindungselemente 2100 mittels einer Leiterbahn 21 des Anschlussabschnitts 220 elektrisch leitend miteinander verbunden sein.

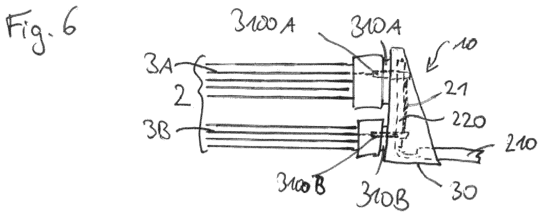

Figur 6 zeigt dies anhand einer schematischen Seitenansicht einer Signalverarbeitungsanordnung mit der Leiterplattenbaugruppe 10 gemäß dem vorstehend beschriebenen ersten Ausführungsbeispiel.

Beispielsweise sind ein erstes Verbindungselement 3100A, das in einem ersten Steckverbinder 310A angeordnet ist und ein zweites Verbindungselement 3100B, dass in einem zweiten Steckverbinder 310B angeordnet ist, mittels der Leiterbahn 21 elektrisch leitend miteinander verbunden. Auf diese Weise sind zwei Kabel 3A, 3B eines Kabelbaums 2, der an das Steckerbauteil 30 der Leiterplattenbaugruppe 10 bzw. des Steuergeräts 1 angeschlossen ist, mittels der Verbindungselemente 3100A, 3100B über die Leiterbahn 21 des Anschlussabschnitts 220 miteinander elektrisch leitend verbunden.

Beispielsweise kann auf diese Weise ein Signal eines ersten Kabelstrangs, zu dem das erste Kabel 3A gehört, über das Steuergerät 1 zu einem zweiten Kabelstrang, zu dem das zweite Kabel 300B gehört, geleitet sein. Das Spleißen der Kabelstränge ist hierzu nicht erforderlich. Der Kabelbaum ist daher beispielsweise frei von Spleißstellen, so dass er besonders einfach und kostengünstig herstellbar ist.

Zum Schutz der Leiterplatte 20 vor Umwelteinflüssen ist diese in einem Innenraum eines Gehäuses des Steuergeräts 1 angeordnet. Das Gehäuse wird beispielsweise von dem Steckerbauteil 30, einem ersten Gehäusebauteil 40 und einem zweiten Gehäusebauteil 50 gebildet. Dabei weist die Gehäuseblende 320 des Steckerbauteils 30 insbesondere ein Plastikmaterial auf. Das erste und das zweite Gehäusebauteil 40, 50 sind beispielsweise Aluminiumgussteile oder Stahlblechteile, insbesondere galvanische verzinkte Stahlblechteile.

Zur Abdichtung des Innenraums weist die Gehäuseblende einen ersten und einen zweiten Dichtungsabschnitt 325, 327 auf, die jeweils mit einem korrespondierenden Abschnitt des zweiten Gehäusebauteils 50 zur Abdichtung des Innenraums zusammenwirken. In Draufsicht auf seine Haupterstreckungsebene 211 ist der Hauptabschnitt 210 der Leiterplatte 20 zwischen dem ersten Dichtungsabschnitt 325 und dem zweiten Dichtungsabschnitt 327 angeordnet. Dabei verlaufen der erste und der zweite Dichtungsabschnitt 325, 327 in Draufsicht auf die Haupterstreckungsebene 211 des Hauptabschnitts 210 insbesondere parallel zu den Längsflanken 212 des Hauptabschnitts 210. Die Längsflanken 212 sind diejenigen Seitenflächen, die parallel zu derjenigen Richtung verlaufen, in der der Hauptabschnitt 210, der Verbindungsabschnitt 230 und der Anschlussabschnitt 220 im gestreckten Zustand der Leiterplatte 20 aufeinander folgen. Insbesondere verlaufen die Längsflanken parallel zur Haupterstreckungsrichtung 3121 der Kontaktstifte 3120 und zum Normalenvektor auf die Haupterstreckungsebene 211 des Hauptabschnitts 210.

Dabei sind der erste und der zweite Dichtungsabschnitt 325, 327 gegenüber der Haupterstreckungsebene 211 des Hauptabschnitts 210 um einen Winkel α geneigt, der beispielsweise einen Wert zwischen 60° und 70° hat, wobei die Grenzen eingeschlossen sind (siehe Figur 2).

Das Steckerbauteil 30 weist zweckmäßigerweise weitere Dichtungsabschnitte 326, 328 auf.. Die weiteren Dichtungsabschnitte 326, 328 verlaufen beispielsweise in Draufsicht auf die Haupterstreckungsebene 211 des Hauptabschnitts 210 U-förmig um den Anschlussabschnitt 220 herum.

Mittels der die Leiterplatte 210 lateral umschließenden ersten und zweiten Dichtungsabschnitte 325, 327 können diese weiteren Dichtungsabschnitte 326, 328 vorteilhafterweise über die gesamte Breite des Steuergeräts 1 parallel zur Haupterstreckungsebene 211 des Hauptabschnitts 210 verlaufen, so dass eine besonders große Breite B1, B2 der Steckverbinder-Reihen 301, 302 erzielbar ist. Der geneigte - nicht senkrechte - Verlauf des ersten und zweiten Dichtungsabschnitts 325, 327 ermöglicht es, beim senkrechten Aufsetzen des zweiten Gehäusebauteils 50 im Bereich des ersten und zweiten Dichtungsabschnitts 325, 327 eine zufriedenstellende Dichtwirkung zu erzielen

Die Erfindung ist nicht durch die Beschreibung anhand der Ausführungsbeispiele auf diese beschränkt. Vielmehr umfasst sie jedes neue Merkmal sowie jede Kombination von Merkmalen, was insbesondere jede Kombination von Merkmalen in den Ausführungsbeispielen und Patentansprüchen beinhaltet.

## Patentansprüche

1. Leiterplattenbaugruppe (10) für ein Steuergerät (1) eines Kraftfahrzeugs mit einer mehrlagigen Leiterplatte (20) und einem Steckerbauteil (30), wobei
- die Leiterplatte (20) einen Hauptabschnitt (210) und einen Anschlussabschnitt (220) sowie einen gekrümmten Verbindungsabschnitt (230) aufweist, der zwischen dem Hauptabschnitt (210) und dem Anschlussabschnitt (220) angeordnet ist und diese mechanisch und elektrisch derart verbindet, dass eine Haupterstreckungsebene (211) des Hauptabschnitts (210) geneigt zu einer Haupterstreckungsebene (221) des Anschlussabschnitts (220) verläuft,
- der gekrümmte Verbindungsabschnitt (230) mittels einer gegenüber dem Hauptabschnitt (210) und dem Anschlussabschnitt (220) verringerten Dicke (h_{V}) und eines glasfaserverstärkten Harzes semiflexibel ausgebildet ist, und
- das Steckerbauteil (30) eine Mehrzahl von Steckverbindern (310) aufweist, wobei jeder Steckverbinder (310) eine Mehrzahl von Verbindungselementen (3100) mit einem Anschlussteil (3110) und einem Kontaktstift (3120) aufweist, wobei die Kontaktstifte (3120) elektrisch und mechanisch mit dem Anschlussabschnitt (220) verbunden sind und eine Haupterstreckungsrichtung (3121) haben, die senkrecht zur Haupterstreckungsebene (221) des Anschlussabschnitts (220) verläuft,
**dadurch gekennzeichnet, dass**
- bei jedem Steckverbinder (310) die Anschlussteile (3110) der Verbindungselemente (3100)in einer gemeinsamen Einfassung (3200) angeordnet sind und
- das Steckerbauteil (30) eine erste und eine zweite Steckverbinder-Reihe (301, 302) aufweist, die jeweils mindestens einen Steckverbinder (310) enthalten und in einer zu der Haupterstreckungsebene (211) des Hauptabschnitts (210) geneigten Stapelrichtung (S) aufeinander folgen, derart dass die erste Steckverbinder-Reihe (301) einen größeren Abstand von dem Hauptabschnitt (210) hat als die zweite Steckverbinder-Reihe (302).

2. Leiterplattenbaugruppe (10) gemäß Anspruch 1, wobei die Stapelrichtung (S) parallel zur Haupterstreckungsebene (221) des Anschlussabschnitts (220) verläuft.

3. Leiterplattenbaugruppe (10) gemäß einem der vorhergehenden Ansprüche, wobei die Breite (B1) der ersten Steckverbinder-Reihe (301) höchstens um 10 % kleiner ist als die Breite (B2) der zweiten Steckverbinder-Reihe (302).

4. Leiterplattenbaugruppe (10) gemäß einem der vorhergehenden Ansprüche, wobei der Anschlussabschnitt (220) in Draufsicht auf seine Haupterstreckungsebene (221) eine rechteckige Grundform hat.

5. Leiterplattenbaugruppe (10) gemäß einem der vorhergehenden Ansprüche, wobei
- das Steckerbauteil (30) eine Gehäuseblende (320) aufweist, aus der die Einfassungen (3200) heraus ragen,
- die Gehäuseblende (320) einen ersten und einen zweiten Dichtungsabschnitt (325, 327) aufweist, die jeweils dazu vorgesehen sind, zur Abdichtung des Steuergeräts (1) mit einem korrespondierenden Dichtungsabschnitt eines Gehäusebauteils (50) des Steuergeräts (1) zusammenzuwirken,
- die Dichtungsabschnitte (325, 327) geneigt zur Haupterstreckungsebene (211) des Hauptabschnitts (210) der Leiterplatte verlaufen, und
- der Hauptabschnitt (210) der Leiterplatte (20) in Draufsicht auf seine Haupterstreckungsebene (211) zwischen dem ersten und dem zweiten Dichtungsabschnitt (325, 327) angeordnet ist.

6. Leiterplattenbaugruppe (10) gemäß einem der vorhergehenden Ansprüche, wobei der Anschlussabschnitt (220) mindestens ein elektronisches Bauelement (2210) aufweist und mittels des elektronischen Bauelements (2210) dazu vorgesehen ist, eine an einem der Verbindungselemente (3100) anliegende Überspannung zu filtern und/oder ein an einem der Verbindungselemente (3100) anliegendes Signal zu glätten und/oder zu verstärken.

7. Leiterplattenbaugruppe (10) gemäß einem der vorhergehenden Ansprüche, wobei ein erstes und ein zweites der Verbindungselemente (3100A, 3100B) mittels einer Leiterbahn (21) des Anschlussabschnitts (220) elektrisch leitend verbunden sind.

8. Leiterplattenbaugruppe (10) gemäß Anspruch 7, wobei das erste und das zweite Verbindungselement (3100A, 3100B) einander nicht unmittelbar benachbart sind.

9. Leiterplattenbaugruppe (10) gemäß Anspruch 8, wobei das erste Verbindungselement (3100A) in einem ersten der Steckverbinder (310A) angeordnet ist und das zweite Verbindungselement (3100B) in einem zweiten der Steckverbinder (310B) angeordnet ist.

10. Steuergerät (1) für ein Kraftfahrzeug mit einer Leiterplattenbaugruppe (10) gemäß einem der vorhergehenden Ansprüche.

11. Signalverarbeitungsanordnung für ein Kraftfahrzeug mit einer Leiterplattenbaugruppe (10) gemäß einem der Ansprüche 7 bis 9 und einem an das Steckerbauteil (30) angeschlossenen Kabelbaum (2), wobei der Kabelbaum (2) frei von Spleißstellen ist und zwei Kabel (3A, 3B) des Kabelbaums (2) mittels des ersten und des zweiten Verbindungselements (3100A, 3100B) über die Leiterbahn (21) des Anschlussabschnitts (220) elektrisch leitend verbunden sind.

## Claims

1. Printed circuit board assembly (10) for a control device (1) of a motor vehicle having a multi-layered printed circuit board (20) and a plug component (30), wherein
- the printed circuit board (20) has a main section (210) and a connection section (220) as well as a curved connecting section (230) which is arranged between the main section (210) and the connection section (220) and connects the latter mechanically and electrically in such a way that a main plane (211) of extent of the main section (210) runs inclined with respect to a main plane (221) of extent of the connection section (220),
- the curved connecting section (230) is made semi-flexible by means of a thickness (hᵥ) which is reduced compared to the main section (210) and the connection section (220), and by means of a glass-fiber-reinforced resin, and
- the plug component (30) has a multiplicity of plug connectors (310), wherein each plug connector (310) has a multiplicity of connecting elements (3100) with a connection part (3110) and a contact pin (3120), wherein the contact pins (3120) are connected electrically and mechanically to the connection section (220) and have a main direction (3121) of extent which runs perpendicularly with respect to the main plane (221) of extent of the connection section (220),
**characterized in that**
- in each plug connector (310) the connection parts (3110) of the connecting elements (3100) are arranged in a common mount (3200) and
- the plug component (30) has a first and a second plug connector row (301, 302) which each contain at least one plug connector (310) and follow one another in a stacking direction (S) which is inclined with respect to the main plane (211) of extent of the main section (210) in such a way that the first plug connector row (301) is at a larger distance from the main section (210) than the second plug connector row (302).

2. Printed circuit board assembly (10) according to Claim 1, wherein the stacking direction (S) runs parallel to the main plane (221) of extent of the connection section (220).

3. Printed circuit board assembly (10) according to one of the preceding claims, wherein the width (B1) of the first plug connector row (301) is at maximum 10% smaller than the width (B2) of the second plug connector row (302).

4. Printed circuit board assembly (10) according to one of the preceding claims, wherein the connection section (220) has a rectangular base shape in a plan view of its main plane (221) of extent.

5. Printed circuit board assembly (10) according to one of the preceding claims, wherein
- the plug component (30) has a housing orifice (320) from which the mounts (3200) project,
- the housing orifice (320) has a first and a second sealing section (325, 327) which are each provided for interacting in order to seal the control device (1) with a corresponding sealing section of a housing component (50) of the control device (1),
- the sealing sections (325, 327) run inclined with respect to the main plane (211) of extent of the main section (210) of the printed circuit board, and
- the main section (210) of the printed circuit board (20) is arranged between the first and the second sealing sections (325, 327) in a plan view of the main plane (211) of extent of said main section (210).

6. Printed circuit board assembly (10) according to one of the preceding claims, wherein the connection section (220) has at least one electronic component (2210) and is provided, by means of the electronic component (2210), for filtering an overvoltage present at one of the connecting elements (3100) and/or for smoothing and/or amplifying a signal present at one of the connecting elements (3100).

7. Printed circuit board assembly (10) according to one of the preceding claims, wherein a first and a second of the connecting elements (3100A, 3100B) are connected in an electrically conductive fashion by means of a conductor track (21) of the connection section (220).

8. Printed circuit board assembly (10) according to Claim 7, wherein the first and second connecting elements (3100A, 3100B) are not directly adjacent to one another.

9. Printed circuit board assembly (10) according to Claim 8, wherein the first connecting element (3100A) is arranged in a first of the plug connectors (310A), and the second connecting element (3100B) is arranged in a second of the plug connectors (310B).

10. Control device (1) for a motor vehicle having a printed circuit board assembly (10) according to one of the preceding claims.

11. Signal processing arrangement for a motor vehicle having a printed circuit board assembly (10) according to one of Claims 7 to 9 and a cable harness (2) connected to the plug component (30), wherein the cable harness (2) is free of splice points, and two cables (3A, 3B) of the cable harness (2) are connected in an electrically conductive fashion by means of the first and second connecting elements (3100A, 3100B), via the conductor track (21) of the connection section (220).

## Revendications

1. Module de cartes de circuit imprimé (10) destiné à un appareil de commande (1) d'un véhicule automobile comportant une carte de circuit imprimé multicouche (20) et un composant connecteur (30), dans lequel
- la carte de circuit imprimé (20) comporte une partie principale (210) et une partie de raccordement (220) ainsi qu'une partie de liaison incurvée (230) qui est disposée entre la partie principale (210) et la partie de raccordement (220) et les relie mécaniquement et électriquement de manière à ce qu'un plan d'extension principale (211) de la partie principale (210) s'étende de manière inclinée par rapport à un plan d'extension principale (221) de la partie de raccordement (220),
- la partie de liaison incurvée (230) est réalisée de manière semi-flexible au moyen d'une épaisseur réduite (hᵥ) par rapport à la partie principale (210) et à la partie de raccordement (220) et d'une résine renforcée par des fibres de verre, et
- le composant connecteur (30) comporte une pluralité de connecteurs (310), dans lequel chaque connecteur (310) comporte une pluralité d'éléments de liaison (3100) comportant une partie de raccordement (3110) et une broche de contact (3120), dans lequel les broches de contact (3120) sont reliées électriquement et mécaniquement à la partie de raccordement (220) et présentent une direction d'extension principale (3121) qui s'étend perpendiculairement au plan d'extension principale (221) de la partie de raccordement (220),
**caractérisé en ce que**
- pour chaque connecteur (310), les parties de raccordement (3110) des éléments de liaison (3100) sont disposées dans un châssis commun (3200) et
- le composant connecteur (30) comporte des première et deuxième rangées de connecteurs (301, 302) qui contiennent respectivement au moins un connecteur (310) et se suivent les unes les autres dans une direction d'empilement (S) inclinée par rapport au plan d'extension principale (211) de la partie principale (210), de manière à ce que la première rangée de connecteurs (301) soit plus éloignée de la partie principale (210) que la deuxième rangée de connecteurs (302).

2. Module de cartes de circuit imprimé (10) selon la revendication 1, dans lequel la direction d'empilement (S) s'étend parallèlement au plan d'extension principale (221) de la partie de raccordement (220).

3. Module de cartes de circuit imprimé (10) selon l'une quelconque des revendications précédentes, dans lequel la largeur (B1) de la première rangée de connecteurs (301) est au plus inférieure d'environ 10 % à la largeur (B2) de la deuxième rangée de connecteurs (302).

4. Module de cartes de circuit imprimé (10) selon l'une quelconque des revendications précédentes, dans lequel la partie de raccordement (220) présente une forme de base rectangulaire dans une vue de dessus de son plan d'extension principale (221).

5. Module de cartes de circuit imprimé (10) selon l'une quelconque des revendications précédentes, dans lequel
- le composant connecteur (30) comporte un panneau de boîtier (320) par rapport auquel les châssis (3200) font saillie vers l'extérieur,
- la panneau de boîtier (320) comporte des première et deuxième parties d'étanchéité (325, 327) qui sont respectivement prévues pour coopérer avec une partie d'étanchéité correspondante d'un composant de boîtier (50) de l'appareil de commande (1) afin de rendre étanche l'appareil de commande (1),
- les parties d'étanchéité (325, 327) s'étendent de manière inclinée par rapport au plan d'extension principale (211) de la partie principale (210) de la carte de circuit imprimé, et
- la partie principale (210) de la carte de circuit imprimé (20) est disposée entre les première et deuxième parties d'étanchéité (325, 327) dans une vue de dessus de son plan d'extension principale (211).

6. Module de cartes de circuit imprimé (10) selon l'une quelconque des revendications précédentes, dans lequel la partie de raccordement (220) comporte au moins un composant électronique (2210) et est conçue pour filtrer au moyen du composant électronique (2210) une surtension appliquée à l'un des éléments de liaison (3100) et/ou pour amplifier et/ou pour lisser un signal appliqué à l'un des éléments de liaison (3100).

7. Module de cartes de circuit imprimé (10) selon l'une quelconque des revendications précédentes, dans lequel des premier et deuxième éléments de liaison (3100A, 3100B) sont reliés de manière électriquement conductrice au moyen d'une piste conductrice (21) de la partie de raccordement (220).

8. Module de cartes de circuit imprimé (10) selon la revendication 7, dans lequel les premier et deuxième éléments de liaison (3100A, 3100B) ne sont pas directement adjacents l'un à l'autre.

9. Module de cartes de circuit imprimé (10) selon la revendication 8, dans lequel le premier élément de liaison (3100A) est disposé dans un premier des connecteurs (310A) et le deuxième élément de liaison (3100B) est disposé dans un deuxième des connecteurs (310B).

10. Appareil de commande (1) destiné à un véhicule automobile comportant un module de cartes de circuit imprimé (10) selon l'une quelconque des revendications précédentes.

11. Système de traitement du signal destiné à un véhicule automobile comportant un module de cartes de circuit imprimé (10) selon l'une quelconque des revendications 7 à 9 et un faisceau de câbles (2) raccordé au composant connecteur (30), dans lequel le faisceau de câbles (2) est dépourvu de points d'épissure et deux câbles (3A, 3B) du faisceau de câbles (2) sont reliés de manière électriquement conductrice au moyen des premier et deuxième éléments de liaison (3100A, 3100B) par l'intermédiaire de la piste conductrice (21) de la partie de raccordement (220).
